# EUROPÄISCHE PATENTANMELDUNG

(11) **EP 4 839 052 A1**
(43) Veröffentlichungstag der Anmeldung: **11.11.2026**
(21) Anmeldenummer: 26172818.2
(22) Anmeldetag: 16.04.2026
(51) Int. Cl.: H10F 19/80, H10F 71/00

(54) **PHOTOVOLTAIKMODUL-RECYCLING**

(30) Priorität: 08.05.2025 DE 102025117641
(71) Anmelder: Stadler Anlagenbau GmbH, 88361 Altshausen (DE)
(72) Erfinder: FIESEL, Roland, 88524 Uttenweiler (DE); BUCK, Tobias, 88356 Ostrach (DE)
(74) Vertreter: RavensPAT Patentanwälte Partnerschaft mbB

(57) **Zusammenfassung**

Vorrichtung 7 zum Recyceln eines Photovoltaikmoduls 8 mittels Trennung einer Glasschicht 5 des Photovoltaikmoduls 8 von einer Modulmatte 6 des Photovoltaikmoduls 8, umfassend einen Fördergurt 4 zur Förderung des Photovoltaikmoduls 8, zumindest eine Antriebswelle 2 zum Antrieb des Fördergurts 4, zumindest eine Umlenkrolle 1 zur Umlenkung des Fördergurts 4, sowie ein Umlenkmittel 9, wobei das Umlenkmittel 9 einen Umlenk-Radius 10 aufweist, um das das Photovoltaikmodul 8 mittels des Fördergurts 4 zwingend geführt ist und der kleiner ist, als der Radius bei dem die Glasschicht des Photovoltaikmoduls 8 unter Verformung einen Sprödbruch erleidet und/oder zersplittert.

## Beschreibung

Im Recyclingprozess eines Photovoltaikmoduls stellt sich die Herausforderung des Trennens des Herstellverbundes der verschiedenen Werkstoffe. Wie generell bei Recyclingverfahren ist die Reinheit der Werkstoffe von hoher Relevanz, um deren Wiederverwendung bestmöglich gewährleisten zu können.

Technische Aufgabe der vorliegenden Erfindung ist es, das Trennen einer Glasschicht von einem Photovoltaikmodul mit hohen Durchlaufmengen zu ermöglichen.

Die technische Aufgabe wird durch einen Gegenstand mir den technischen Merkmalen nach den unabhängigen Ansprüchen gelöst. Vorteilhafte Ausführungsformen sind Gegenstand der abhängigen Ansprüche, der Beschreibung und der Figuren.

Im Sinne der Erfindung kann unter dem Begriff eines Photovoltaikmoduls ein Solarmodul, ein PV-Modul, ein Solarpanel oder Ähnliches verstanden werden, das Licht der Sonne direkt in elektrische Energie umwandelt. Ein Solches besteht aus Solarzellen, die in Reihe oder zueinander parallelgeschaltet sind und allgemein bekannt sind.

Im Sinne der Erfindung kann unter einer Glasschicht des Photovoltaikmoduls jede spröde Schicht einer insbesondere starren Solarzelle verstanden werden, die in der Regel aus Gläsern oder Glasplatten hergestellt ist und zwischen denen oder an denen die Solarzellen verkapselt sind. Wird eine solche Glasschicht gebrochen, zersplittert diese in der Regel und es entstehen entsprechenden Glassplitter.

Im Sinne der Erfindung sind unter dem Begriff einer Modulmatte diejenigen Bestandteile eines Photovoltaikmoduls zu verstehen, die zusätzlich zu einer Glasschicht das Photovoltaikmoduls, insbesondere ohne dessen Rahmen, bilden.

Im Sinne der Erfindung sind die Begriffe zerbrochen und gebrochen als äquivalent aufzufassen.

Im Sinne der Erfindung ist unter dem Begriff eines Sprödbruchs ein schlagartig auftretendes Materialversagen zu verstehen, dass wie beispielsweise auch der Trennbruch, oder Spaltbruch oder Gewaltbruch bei harten und spröden Materialien, wie beispielsweise Glas auftritt, und in diesem Beispiel zu einem zersplittern dieses Materials führt.

Gemäß einem Aspekt wird die technische Aufgabe der Erfindung gelöst, mittels einer Vorrichtung zum Recyceln eines Photovoltaikmoduls mittels Trennung einer Glasschicht des Photovoltaikmoduls von einer Modulmatte des Photovoltaikmoduls, umfassend einen Fördergurt zur Förderung des Photovoltaikmoduls, zumindest eine Antriebswelle zum Antrieb des Fördergurts, zumindest eine Umlenkrolle zur Umlenkung des Fördergurts, sowie ein Umlenkmittel, wobei das Umlenkmittel einen Umlenk-Radius aufweist, um das das Photovoltaikmoduls mittels des Fördergurts zwingend geführt ist und der kleiner ist, als der Radius bei dem die Glasschicht des Photovoltaikmoduls unter Verformung einen Sprödbruch erleidet und/oder zersplittert.

Die in der Regel aus einer Glasschicht erzeugte Verkapselung eines Photovoltaikmoduls kann somit vorteilhaft gebrochen werden, wodurch in technischer Wirkung Glassplitter aus der Glasschicht entstehen, die am Rest der Modulmatte nicht länger haften und somit entweder von dieser einfach abfallen oder sehr leicht abgetragen werden können. Die Vorrichtung kann kontinuierlich betrieben werden, was somit eine einfache und in hohem Durchsatz durchführbare Trennung von Glasschicht und Modulmatte ermöglichen kann.

In einer technisch vorteilhaften Ausführungsform der Vorrichtung ist vorgesehen, dass das Umlenkmittel im gemeinsamen Zusammenwirken mit dem Fördergurt derart ausgebildet sind, sodass wenn ein Photovoltaikmodul in die Vorrichtung eingeführt wird, das Photovoltaikmodul, insbesondere zumindest teilweise, um das Umlenkmittel herum und bevorzugt mit der Glasschicht in Richtung Umlenkmittel gerichtet, zwangsgeführt ist.

Vorteilhaft kann so ein prozesssicheres Führen des Photovoltaikmoduls ermöglicht werden und ein kontrolliertes Brechen, sowie ein kontrollierter Bruch der Glasschicht gewährleistet werden. Das kontrollierte Brechen kann beispielsweise in der Art verstanden werden, als dass der Vorgang des Brechens der Glasschicht kontrolliert und präzise durchgeführt werden kann. Der kontrollierte Bruch der Glasschicht kann beispielsweise in der Art verstanden werden, als dass der Bruch und somit insbesondere eine mögliche Körnung der sich ergebenden Glassplitter kontrolliert werden kann.

Außerdem ist in einer technisch vorteilhaften Ausführungsform der Vorrichtung vorgesehen, dass das Umlenkmittel als Umlenkrolle oder als Antriebswelle ausgebildet ist.

Vorteilhaft können so einzelne und zum Betrieb der Vorrichtung benötigte Elemente der Vorrichtung in ihrer Funktion miteinander vereint werden, wodurch zusätzliche Elemente vermieden und eine einfache Konstruktion ermöglicht werden kann. Insbesondere bietet dieses den Vorteil, als dass auf Grund geringerer Elemente die Ausfallsicherheit verbessert und insbesondere eine Wartungs- und Reinigungsfreundlichkeit erhöht werden kann.

Darüber hinaus ist in einer technisch vorteilhaften Ausführungsform der Vorrichtung vorgesehen, dass zumindest eine Umlenkrolle zu den übrigen Umlenkrollen lösbar und/oder versetzbar ausgebildet ist.

Vorteilhaft kann so bei technischen Problemen oder bei einem Verkannten des Photovoltaikmoduls innerhalb der Vorrichtung, diese zügig demontiert, insbesondere der Fördergurt gelöst, oder gewartet werden.

In einer weiteren technisch vorteilhaften Ausführungsform der Vorrichtung ist vorgesehen, dass zumindest eine Umlenkrolle als Spannrolle ausgebildet, wobei der Fördergurt mittels der Spannrolle gespannt ist, insbesondere zur Erzeugung eines definierten Anpressdrucks zwischen dem Fördergurt und dem Umlenkmittel gespannt ist.

Vorteilhaft kann somit eine Verdrängung des Photovoltaikmoduls zwischen Fördergurt und Umlenkmittel ausgeglichen und in Abhängigkeit einer Dicke des Photovoltaikmoduls stets ein gleichbleibender und gegebenenfalls zu verändernder Anpressdruck eingestellt werden. Zusätzlich kann so auf einfache Art und Weise den umlaufenden Fördergurt gespannt werden und insbesondere mittels der so anliegenden bzw. einstellbaren Spannung auch ein Ergebnis des Bruchs der Glasschicht eingestellt werden. Beispielsweise könnte so eine Korngröße der Glassplitter eingestellt werden, was entsprechende Vorteile birgt.

Außerdem ist in einer technisch vorteilhaften Ausführungsform der Vorrichtung vorgesehen, dass die Vorrichtung Zuführmittel und/oder Fixierungsmittel und/oder Haltemittel zur, insbesondere zwangsgeführten, Zuführung in die Vorrichtung und/oder zur Führung in der Vorrichtung umfasst.

Bereits genannte Vorteile kommen auch dadurch zum Tragen. Insbesondere kann vorteilhaft ein prozesssicheres Zuführen ermöglicht werden.

Weiterhin ist in einer technisch vorteilhaften Ausführungsform der Vorrichtung vorgesehen, dass die Vorrichtung eine Betriebsgeschwindigkeit aufweist, in Folge derer ein ballistisches separieren von zerbrochener Glasschicht und Modulmatte beim Auswerfen des Photovoltaikmoduls ermöglicht ist.

Vorteilhaft kann so das Trennen von Glasschicht von Modulmatte mit bekannten Mitteln und Verfahren verbessert werden.

Darüber hinaus ist in einer technisch vorteilhaften Ausführungsform der Vorrichtung vorgesehen, dass die Vorrichtung Mittel zum Auffangen oder Separieren der von der Modulmatte separierten und gebrochenen Glasschicht umfasst.

Als Mittel zum Separieren können beispielsweise ein Rollenfeld oder ein Separationsgitter vorgesehen sein, durch das die aus dem Brechen des Glases entstehende Glassplitter fallen und über das die Modulmatte weiter hinweg getragen werden kann.

Weiterhin ist in einer technisch vorteilhaften Ausführungsform der Vorrichtung vorgesehen, dass die Vorrichtung Mittel zum Tempern des Photovoltaikmoduls umfasst.

Vorteilhaft kann so das Photovoltaikmodul mit einer gewissen Temperatur beaufschlagt werden, was sich günstig auf das Brechen und/oder das Lösen der Glasschicht von der Modulmatte auswirken kann.

Gemäß einem weiteren Aspekt wird die technische Aufgabe der Erfindung gelöst mittels eines Verfahrens zum Recyceln eines Photovoltaikmoduls, insbesondere mittels einer Vorrichtung nach einem der vorangehenden Ansprüche, wobei zur Trennung einer Glasschicht des Photovoltaikmoduls von der Modulmatte des Photovoltaikmoduls, das Photovoltaikmodul derart umgelenkt wird, sodass die Glasschicht bricht und/oder zersplittert und sie somit zu einem Ablösen von der Modulmatte gezwungen wird, wobei zur Trennung der Glasschicht des Photovoltaikmoduls von der Modulmatte des Photovoltaikmoduls, das Photovoltaikmoduls insbesondere um einen Umlenk-Radius umgelenkt wird, der kleiner ist, als der Radius bei dem die Glasschicht des Photovoltaikmoduls unter Verformung einen Sprödbruch erleidet und/oder zersplittert.

Vorteilhaft können so die bereits genannten Vorteile auch im Rahmen eines Verfahrens zur Anwendung gelangen.

In einer technisch vorteilhaften Ausführungsform des Verfahrens, insbesondere mittels einer Vorrichtung nach einem der vorangehenden Ansprüche, ist vorgesehen, dass das Photovoltaikmodul zunächst einen Temperschritt erfährt, wobei das Photovoltaikmodul insbesondere auf eine von einer Umgebungstemperatur verschiedene Temperatur aufgeheizt wird, wobei bevorzugt das Photovoltaikmodul auf eine Temperatur zwischen 65 °C und 85 °C aufgeheizt wird.

Vorteilhaft kann so das Trennen der Glasschicht von der Modulmatte verbessert werden. Insbesondere kann so das Brechen der Glasschicht optimiert und der Bruch der Glasschicht kontrolliert werden. Beispielsweise kann dies zusätzlich zur Verbesserung einer kontrollierten Korngröße der Glassplitter herangezogen werden.

Darüber hinaus ist in einer technisch vorteilhaften Ausführungsform des Verfahrens, insbesondere mittels einer Vorrichtung nach einem der vorangehenden Ansprüche, vorgesehen, dass das Verfahren die folgenden Verfahrensschritte, insbesondere in der folgenden Reihenfolge, umfasst:
a) Aufheizen des Photovoltaikmoduls,
   insbesondere auf eine Temperatur zwischen 65 °C und 85 °C,
   bevorzugt mittels Mittel zum Tempern des Photovoltaikmoduls (15).
b) Zuführen des Photovoltaikmoduls mittels Fördertechnik in die Vorrichtung und an eine Umlenkrolle anliegend,
   wobei das Photovoltaikmodul mit seiner Glasseite zu dem Umlenkmittel gerichtet, in die Vorrichtung zugeführt wird;
c) Umlenken des Photovoltaikmoduls um das Umlenkmittel zum Bruch der Glasschicht (5) des Photovoltaikmoduls;
d) Auswerfen der Modulmatte und der zerbrochenen Glasschicht;
e) Auffangen der zerbrochenen Glasschicht einerseits und hiervon getrenntes Auffangen der Modulmatte des Photovoltaikmoduls andererseits,
   insbesondere mittels Mittel zum Auffangen oder Separieren (14).

Die bereits genannten Vorteile kommen auch hier zum Tragen.

Ausführungsbeispiele der Erfindung sind in den Figuren dargestellt. Diese werden im Folgenden näher beschrieben.

Es zeigen:

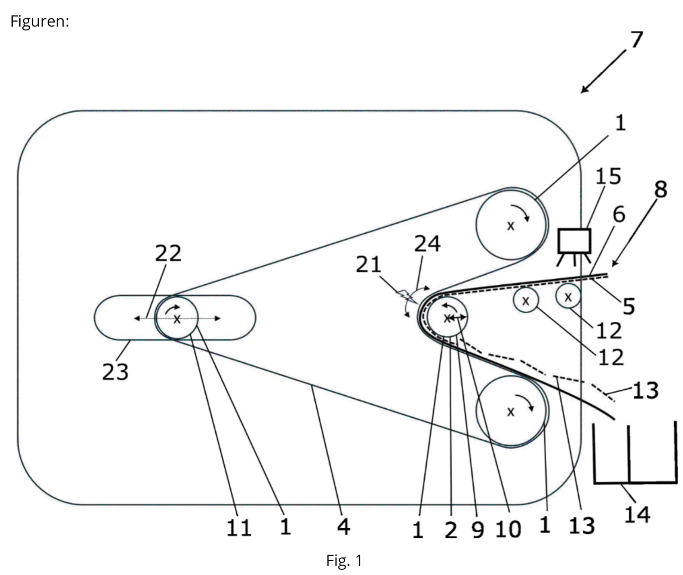

- Fig. 1: eine schematische Darstellung der Vorrichtung zum Recyceln eines Photovoltaikmoduls ; sowie

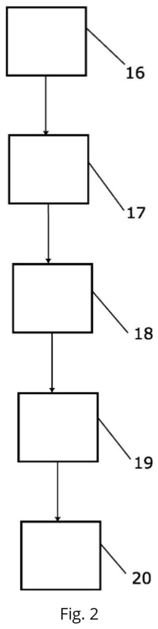

- Fig. 2: eine schematische Darstellung des Verfahrens zum Recyceln eines Photovoltaikmoduls.

In einer Zusammenschau der Figuren ist das Folgende dargestellt.

Die Figuren zeigen schematisch eine Vorrichtung zum Recyceln eines Photovoltaikmoduls mittels Trennung einer Glasschicht des Photovoltaikmoduls von einer Modulmatte des Photovoltaikmoduls. Diese Vorrichtung umfasst einen Fördergurt 4 zur Förderung des Photovoltaikmoduls 8, eine Antriebswelle 2 zum Antrieb des Fördergurts 4, zumindest eine Umlenkrolle 1 zur Umlenkung des Fördergurts 4, sowie ein Umlenkmittel 9, wobei das Umlenkmittel 9 einen Umlenk-Radius 10 aufweist, um das das Photovoltaikmodul 8 mittels des Fördergurts 4 zwingend geführt ist und der kleiner ist, als der Radius bei dem die Glasschicht des Photovoltaikmoduls 8 unter Verformung einen Sprödbruch erleidet und/oder zersplittert.

Vorteilhaft kommen hier die bereits genannten Vorteile zum Tragen. Insbesondere kann ein in die Vorrichtung eingeführtes Photovoltaikmodul günstig und schnell in seine Bestandteile, die Glasschicht und die Modulmatte, zerlegt werden. Im kontinuierlichen Betrieb wird die Glasschicht zu Glassplittern gebrochen, wodurch sie sich von der Modulmatte ablöst und sich von ihr trennt. Die Glassplitter bieten darüber hinaus den Vorteil, dass eine einfache Weiterverarbeitung oder selbst auch nur ein einfacher Weitertransport dieses Rohstoffs ermöglich werden kann. Die Vorrichtung kann vorteilhaft wartungsarm betrieben werden und eine, insbesondere durch ungeschulte Kräfte, schnelle Wartung und Reinigung kann ermöglicht werden.

Außerdem ist dargestellt, dass das Umlenkmittel 9 im gemeinsamen Zusammenwirken mit dem Fördergurt 4 derart ausgebildet sind, sodass wenn ein Photovoltaikmodul 8 in die Vorrichtung eingeführt wird, das Photovoltaikmodul 8 um das Umlenkmittel 9 herum und mit der Glasschicht 5 in Richtung Umlenkmittel 9 gerichtet, zwangsgeführt ist. Weiterhin ist dargestellt, dass das Umlenkmittel 9 als Antriebswelle 2 ausgebildet ist. Darüber hinaus ist dargestellt, dass zumindest eine Umlenkrolle 1 zu den übrigen Umlenkrollen 1 lösbar und versetzbar ausgebildet ist.

Dargestellt ist außerdem, dass zumindest eine Umlenkrolle 1 als Spannrolle 11 ausgebildet, wobei der Fördergurt 4 mittels der Spannrolle 11 gespannt ist, insbesondere zur Erzeugung eines definierten Anpressdrucks zwischen dem Fördergurt 4 und dem Umlenkmittel 9 gespannt ist. Weiterhin ist dargestellt, dass die Vorrichtung Zuführmittel 12 und Fixierungsmittel 12 und Haltemittel 12 zur zwangsgeführten Zuführung in die Vorrichtung und zur Führung in der Vorrichtung umfasst. Weiterhin ist dargestellt, dass die Vorrichtung Mittel zum Auffangen oder Separieren der von der Modulmatte separierten und gebrochenen Glasschicht 13 umfasst. Auch ist dargestellt, dass die Vorrichtung Mittel zum Tempern 14 des Photovoltaikmoduls umfasst. Das Photovoltaikmodul wird mittels des Umlenkmittels 9 im Zusammenwirken mit und in Führung durch den Fördergurt 4 um einen Biegeradius, bzw. eine Krümmung 24 derart gekrümmt, sodass es zu einem Bruch 21 der Glasschicht 5 des Photovoltaikmoduls 8 kommt. Eine Spannung des Fördergurtes 4 kann zudem vorteilhaft mittels Versatz der Spannrolle 11 in einer Versatzrichtung 22 justiert und wunschgemäß angepasst werden, was sich insbesondere mittels eines schematisch dargestellten Langloch 23 einfach verwirklichen lässt. Auch andere Führungen der Spannrolle 11 können vorgesehen sein.

Außerdem ist ein Verfahren zum Recyceln eines Photovoltaikmoduls 8, insbesondere mittels einer Vorrichtung 7 nach einem der vorangehenden Ansprüche, dargestellt, wobei zur Trennung einer Glasschicht 5 des Photovoltaikmoduls 8 von der Modulmatte 6 des Photovoltaikmoduls 8, das Photovoltaikmoduls 8 derart umgelenkt wird, sodass die Glasschicht 5 bricht und/oder zersplittert und sie somit zu einem Ablösen von der Modulmatte 6 gezwungen wird, wobei zur Trennung der Glasschicht 5 des Photovoltaikmoduls 8 von der Modulmatte 6 des Photovoltaikmoduls 8, das Photovoltaikmodul 8 insbesondere um einen Umlenk-Radius 10 umgelenkt wird, der kleiner ist, als der Radius bei dem die Glasschicht des Photovoltaikmoduls 5 unter Verformung einen Sprödbruch erleidet und/oder zersplittert. Weiterhin ist dargestellt, dass das Photovoltaikmodul 8 zunächst einen Temperschritt erfährt, wobei das Photovoltaikmodul 8 insbesondere auf eine von einer Umgebungstemperatur verschiedene Temperatur aufgeheizt wird, wobei bevorzugt das Photovoltaikmodul 8 auf eine Temperatur zwischen 65 °C und 85 °C aufgeheizt wird.

Darüber hinaus ist dargestellt, dass das Verfahren, insbesondere Mittels einer vorangehend beschriebenen Vorrichtung, die folgenden Verfahrensschritte umfasst:
a) Aufheizen des Photovoltaikmoduls 8,
   insbesondere auf eine Temperatur zwischen 65 °C und 85 °C,
   bevorzugt mittels Mittel zum Tempern des Photovoltaikmoduls 15.
b) Zuführen des Photovoltaikmoduls 8 mittels Fördertechnik in die Vorrichtung und an eine Umlenkrolle anliegend,
   wobei das Photovoltaikmodul 8 mit seiner Glasseite zu dem Umlenkmittel 9 gerichtet, in die Vorrichtung zugeführt wird;
c) Umlenken des Photovoltaikmoduls 8 um das Umlenkmittel 8 zum Bruch der Glasschicht 5 des Photovoltaikmoduls 8;
d) Auswerfen der Modulmatte 6 und der zerbrochenen Glasschicht 13;
e) Auffangen der zerbrochenen Glasschicht 13 einerseits und hiervon getrenntes Auffangen der Modulmatte 6 des Photovoltaikmoduls 8 andererseits,
   insbesondere mittels Mittel zum Auffangen oder Separieren 14.

### Bezugszeichen:

- 1: Umlenkrolle
- 2 3: Antriebswelle
- 4: Fördergurt
- 5: Glasschicht des Photovoltaikmoduls
- 6: Modulmatte des Photovoltaikmoduls
- 7: Vorrichtung
- 8: Photovoltaikmodul
- 9: Umlenkmittel
- 10: Umlenk-Radius
- 11: Spannrolle
- 12: Zuführmittel und/oder Fixierungsmittel und/oder Haltemittel
- 13: zerbrochene Glasschicht; Glassplitter
- 14: Mittel zum Auffangen oder Separieren
- 15: Mittel zum Tempern des Photovoltaikmoduls
- 16: Verfahrensschritt a): Aufheizen
- 17: Verfahrensschritt b): Zuführen
- 18: Verfahrensschritt c): Umlenken
- 19: Verfahrensschritt d): Auswerfen
- 20: Verfahrensschritt e): Auffangen
- 21: Bruch
- 22: Versatzrichtung
- 23: Langloch
- 24: Biegeradius bzw. Krümmung

## Patentansprüche

1. Vorrichtung (7) zum Recyceln eines Photovoltaikmoduls (8) mittels Trennung einer Glasschicht (5) des Photovoltaikmoduls (8) von einer Modulmatte (6) des Photovoltaikmoduls (8), umfassend
einen Fördergurt (4) zur Förderung des Photovoltaikmoduls (8),
zumindest eine Antriebswelle (2) zum Antrieb des Fördergurts (4),
zumindest eine Umlenkrolle (1) zur Umlenkung des Fördergurts (4),
sowie ein Umlenkmittel (9),
wobei das Umlenkmittel (9) einen Umlenk-Radius (10) aufweist, um das das Photovoltaikmodul (8) mittels des Fördergurts (4) zwingend geführt ist und der kleiner ist, als der Radius bei dem die Glasschicht des Photovoltaikmoduls (8) unter Verformung einen Sprödbruch erleidet und/oder zersplittert.

2. Vorrichtung (7) nach Anspruch 1
wobei das Umlenkmittel (9) im gemeinsamen Zusammenwirken mit dem Fördergurt (4) derart ausgebildet sind, sodass wenn ein Photovoltaikmodul (8) in die Vorrichtung eingeführt wird, das Photovoltaikmodul (8),
insbesondere zumindest teilweise,
um das Umlenkmittel (9) herum
und bevorzugt mit der Glasschicht (5) in Richtung Umlenkmittel (9) gerichtet, zwangsgeführt ist.

3. Vorrichtung (7) nach einem der vorangehenden Ansprüche,
wobei das Umlenkmittel (9) als Umlenkrolle (1) oder als Antriebswelle (2) ausgebildet ist.

4. Vorrichtung (7) nach einem der vorangehenden Ansprüche,
wobei zumindest eine Umlenkrolle (1) zu den übrigen Umlenkrollen (1) lösbar und/oder versetzbar ausgebildet ist.

5. Vorrichtung (7) nach einem der vorangehenden Ansprüche,
wobei zumindest eine Umlenkrolle (1) als Spannrolle (11) ausgebildet, wobei der Fördergurt (4) mittels der Spannrolle (11) gespannt ist,
insbesondere zur Erzeugung eines definierten Anpressdrucks zwischen dem Fördergurt (4) und dem Umlenkmittel (9) gespannt ist.

6. Vorrichtung (7) nach einem der vorangehenden Ansprüche,
wobei die Vorrichtung Zuführmittel (12) und/oder Fixierungsmittel (12) und/oder Haltemittel (12) zur,
insbesondere zwangsgeführten,
Zuführung in die Vorrichtung
und/oder zur Führung in der Vorrichtung umfasst.

7. Vorrichtung (7) nach einem der vorangehenden Ansprüche,
wobei die Vorrichtung eine Betriebsgeschwindigkeit aufweist, in Folge derer ein ballistisches separieren von zerbrochener Glasschicht (13) und Modulmatte (6) beim Auswerfen des Photovoltaikmoduls (8) ermöglicht ist.

8. Vorrichtung (7) nach einem der vorangehenden Ansprüche,
wobei die Vorrichtung Mittel zum Auffangen oder Separieren (14) der von der Modulmatte separierten und gebrochenen Glasschicht (13) umfasst.

9. Vorrichtung (7) nach einem der vorangehenden Ansprüche,
wobei die Vorrichtung Mittel zum Tempern (15) des Photovoltaikmoduls umfasst.

10. Verfahren zum Recyceln eines Photovoltaikmoduls (8),
insbesondere mittels einer Vorrichtung (7) nach einem der vorangehenden Ansprüche,
wobei zur Trennung einer Glasschicht (5) des Photovoltaikmoduls (8) von der Modulmatte (6) des Photovoltaikmoduls (8), das Photovoltaikmoduls (8) derart umgelenkt wird, sodass die Glasschicht (5) bricht und/oder zersplittert und sie somit zu einem Ablösen von der Modulmatte (6) gezwungen wird,
wobei zur Trennung der Glasschicht (5) des Photovoltaikmoduls (8) von der Modulmatte (6) des Photovoltaikmoduls (8), das Photovoltaikmodul (8) insbesondere um einen Umlenk-Radius (10) umgelenkt wird, der kleiner ist, als der Radius bei dem die Glasschicht des Photovoltaikmoduls (5) unter Verformung einen Sprödbruch erleidet und/oder zersplittert.

11. Verfahren nach einem der vorangehenden Ansprüche,
insbesondere mittels einer Vorrichtung (7) nach einem der vorangehenden Ansprüche,
wobei das Photovoltaikmodul (8) zunächst einen Temperschritt erfährt,
wobei das Photovoltaikmodul (8) insbesondere auf eine von einer Umgebungstemperatur verschiedene Temperatur aufgeheizt wird,
wobei bevorzugt das Photovoltaikmodul (8) auf eine Temperatur zwischen 65 °C und 85 °C aufgeheizt wird.

12. Verfahren nach einem der vorangehenden Ansprüche,
insbesondere mittels einer Vorrichtung (7) nach einem der vorangehenden Ansprüche,
umfassend die Verfahrensschritte:
a) Aufheizen (16) des Photovoltaikmoduls (8),
insbesondere auf eine Temperatur zwischen 65 °C und 85 °C,
bevorzugt mittels Mittel zum Tempern des Photovoltaikmoduls (15).
b) Zuführen (17) des Photovoltaikmoduls (8) mittels Fördertechnik in die Vorrichtung und an eine Umlenkrolle anliegend,
wobei das Photovoltaikmodul (8) mit seiner Glasseite zu dem Umlenkmittel (9) gerichtet, in die Vorrichtung zugeführt wird;
c) Umlenken (18) des Photovoltaikmoduls (8) um das Umlenkmittel (8) zum Bruch der Glasschicht (5) des Photovoltaikmoduls (8);
d) Auswerfen (19) der Modulmatte (6) und der zerbrochenen Glasschicht (13);
e) Auffangen (20) der zerbrochenen Glasschicht (13) einerseits und hiervon getrenntes Auffangen der Modulmatte (6) des Photovoltaikmoduls (8) andererseits,
insbesondere mittels Mittel zum Auffangen oder Separieren (14).
